# EUROPÄISCHE PATENTSCHRIFT

(11) **EP 0 810 300 B1**
(45) Veröffentlichungstag und Bekanntmachung des Hinweises auf die Patenterteilung: **09.04.2003**
(21) Anmeldenummer: 97108339.9
(22) Anmeldetag: 22.05.1997
(51) Int. Cl.: C23C 14/58, C23C 14/14, C23C 16/56, C23C 16/20, H01L 21/3205

(54) **Herstellverfahren für eine Aluminiumschicht**
Process for producing an aluminium film
Procédé de fabrication d'une couche d'aluminium

(30) Priorität: 28.05.1996 DE 19621400
(43) Veröffentlichungstag der Anmeldung: 03.12.1997
(73) Patentinhaber: Infineon Technologies AG, 80506 München (DE)
(72) Erfinder: Schneegans, Manfred, Dr., 85591 Vaterstetten (DE); Dietrich, Stefan, 82299 Türkenfeld (DE); Hirsch, Alexander, 85521 Ottobrunn (DE)
(74) Vertreter: Zimmermann, Gerd Heinrich

(56) Entgegenhaltungen:
- US-A- 3 848 330
- US-A- 4 566 177
- US-A- 5 300 307
- METALLURGICAL TRANSACTIONS A PHYSICAL METALLURGY AND MATERIALS SCIENCE., Bd. 21, September 1990, NEW YORK US, Seiten 2449-2458, XP002040151 FREAR ET AL.: "The Evolution of Microstructure in Al-2 Pct Cu Thin Films: Precipitation, Dissolution and Reprecipitation"
- MATERIALS RELIABILITY IN MICROELECTRONICS III SYMPOSIUM, MATERIALS RELIABILITY IN MICROELECTRONICS III SYMPOSIUM, SAN FRANCISCO, CA, USA, 12-15 APRIL 1993, 1993, PITTSBURGH, PA, USA, MATER. RES. SOC, USA, Seiten 383-394, XP002040152 THOMPSON C V: "The effect of thermal history on interconnect reliability"

## Beschreibung

Die Erfindung betrifft ein Herstellverfahren für eine Aluminiumschicht auf einem Substrat.

Aluminium ist bis heute das fast ausschließlich verwendete Metall für Leiterbahnen in der Halbleitertechnologie, da es die an Leiterbahnen gestellten Anforderungen sehr gut zu erfüllen vermag.

Allerdings weist Aluminium auch mehrere negative Eigenschaften auf, die bisher nicht oder nicht vollständig beseitigt werden konnten.

Eine dieser besonders negativen Eigenschaften ist die ausgeprägte Elektromigration in Aluminiumleiterbahnen. Unter Elektromigration versteht man die Materialwanderung in Leiterbahnen unter dem Einfluß eines elektrischen Stromes. Dabei kommt es aufgrund der Stöße von bewegten Elektronen mit den positiv geladenen Aluminiumrümpfen der Kristallstruktur zu einer Materialverarmung in Richtung des Elektronenflusses. Diese Materialverarmung kann lokal zur vollständigen Unterbrechung einer Leiterbahn und damit zum Totalausfall einer integrierten Schaltung führen.

Ferner kann es bei Aluminiumleiterbahnen noch zu der sogenannten Stressmigration kommen. Darunter versteht man die Wanderung von Aluminiumatomen unter dem Einfluß innerer mechanischer Spannungen bei erhöhter Temperatur. Auch die Stressmigration kann letztendlich zu einer Unterbrechung einer Leiterbahn und damit zum Totalausfall einer integrierten Schaltung führen. Als Gegenmaßnahme gegen die Stressmigration und die Elektromigration hat sich ein Zusatz von ungefähr 0,5 bis 5 Gewichtsprozent Kupfer zum Aluminium bewährt.

Bei sehr schmalen Aluminiumleiterbahnen (Breite ≤ 1 µm) in höchst integrierten Schaltkreisen zeigen sich jedoch trotz des genannten Legierungszusatzes von Kupfer Leiterbahnrisse und Leiterbahnunterbrechungen, die schon nach passiver Temperaturlagerung bei geringen Temperaturen (125°C) auch ohne Strombelastung immer häufiger auftreten.

Besonders betroffen sind Mehrlagenmetallisierungen mit SiO₂-Dielektrika als Unterlagen und SiO₂/SiNₓ-Deckschichten in den oberen Metallebenen. Der Grund dafür sind die dort auftretenden sehr starken extrinsischen Zugspannungen. Als Ursache konnte ermittelt werden, daß das spätere spaltförmige Aufreisen der Aluminiumleiterbahnen in der Abkühlphase beim Tempern oder beim Polyimidvernetzen liegt. Die dort prozeßbedingte Abkühlcharakteristik bewirkt, daß es während der Abkühlung zur Auslagerung von flächigen Kupferausscheidungen, sogenannten Guinier-Preston-Phasen, in den gewachsenen Aluminiumkörnern kommt. Bei den bisher üblichen Abkühlphasen wandern die Kupferatome aus dem Inneren der Aluminiumkörner an die Korngrenzen, um sich dort in die stabilen Al₂Cu-θ-Phasen umzuwandeln. Dabei hinterlassen sie offene oder durch Versetzungen stark gestörte Gitterebenen, die von den Aluminiumatomen nicht vollständig ausgeheilt werden können.

D.R. Frear et al. beschreiben im Metallurgical Transactions 21A (1990), 2445 - 2458 Untersuchungen zur Al₂Cu-Θ-Phasenbildung in Al-Cu-Legierungen mit 2 Gew-% Kupfer-Anteil. Dort wird beschrieben, daß die Hitzebehandlung eines dünnen Films einer solchen Al-Cu-Legierungen auf 425°C für 35 min zu der Ausbildung von Al₂Cu-Θ-Phasen an den Al-Korngrenzen führt.

Der Erfindung liegt daher die Aufgabe zugrunde, ein Herstellverfahren für eine Aluminiumschicht anzugeben, bei der diese offenen und durch Versetzungen stark gestörten Gitterebenen innerhalb der Aluminiumkörner vermieden werden.

Diese Aufgabe wird erfindungsgemäß gelöst durch ein Herstellverfahren für eine Aluminiumschicht auf einem Substrat mit folgenden Schritten:
a) auf dem Substrat wird eine polykristalline Aluminiumschicht, die zwischen 0,5 - 5 Gewichtsprozent Kupfer enthält, abgeschieden,
b) das Substrat mit der polykristallinen Aluminiumschicht wird in einem Ofen eingebracht und dort auf eine Zieltemperatur aufgeheizt,
c) danach wird das Substrat mit der polykristallinen Aluminiumschicht im Ofen von der Zieltemperatur auf eine Endtemperatur kontrolliert abgekühlt, so daß beim kontrollierten Abkühlen die momentane Temperatur ein vorgegebenes Temperaturprofil im Temperaturintervall von 320°C bis 200°C durchläuft und das Abkühlen im Temperaturintervall von 320°C bis 200°C mit einer zeitlichen Änderung der Temperatur kleiner 6°C pro Stunde erfolgt, wobei in der Aluminiumschicht zwischen den einzelnen Aluminiumkörnern direkt energetisch stabile Al₂Cu-θ-Phasen gebildet werden.

Die Erfindung nutzt dabei die Erkenntnis, daß durch einen Temperatur-Reifungsprozeß die energetisch stabilen Al₂Cu-θ-Phasen aus der Mischphase direkt und ohne Zwischenstufe der Guinier-Preston-Phasen in den Korngrenzen zwischen Aluminiumkörnern gebildet werden können. Dadurch entfällt das Ausdiffundieren der instabilen, großflächigen Kupferausscheidungen aus dem Inneren der Aluminiumkörner und es bilden sich nach dem Temperatur-Reifungsprozeß keine spaltförmigen Leer- oder Versetzungsflächen.

In einer Ausführungsform des Herstellverfahrens wird die polykristalline Aluminiumschicht auf der Zieltemperatur von ungefähr 450°C getempert.

In einer alternativen Ausführungsform des erfindungsgemäßen Herstellverfahrens wird eine auf der Aluminiumschicht aufgebrachte Imidschicht bei einer Zieltemperatur von ungefähr 360°C polymerisiert.

Nach Beendigung des Temperns bzw. des Polymerisierens erfolgt ein kontrolliertes Abkühlen, wobei die momentane Temperatur ein vorgegebenes Temperaturprofil im Temperaturintervall von 320°C bis 200°C durchläuft. Dabei erfolgt eine zeitliche Änderung der Temperatur, die kleiner 6°C pro Stunde ist.

Eine Möglichkeit zur Herstellung der polykristallinen Aluminiumschicht besteht darin, daß sie durch Sputtern bei einer Temperatur zwischen z. B. 200°C und 400°C auf dem Substrat abgeschieden wird.

Eine weitere Möglichkeit zur Herstellung der polykristallinen Aluminiumschicht besteht darin, daß sie mittels thermischer, induktiver oder Elektronenstrahl-Verdampfung auf dem Substrat abgeschieden wird.

Des weiteren besteht die Möglichkeit, die polykristalline Aluminiumschicht durch ein sogenanntes CVD-Verfahren z. B. mit Triisobutylaluminium als Ausgangssubstanz auf dem Substrat abzuscheiden.

Im folgenden wird die Erfindung anhand eines Ausführungsbeispieles näher erläutert.

Ausgangspunkt ist in beiden Fällen, daß auf ein Substrat aus z. B. Siliziumdioxid eine polykristalline Aluminiumschicht, die zwischen 0,5 bis 5 Gewichtsprozent Kupfer enthält, abgeschieden. Dies erfolgt z. B. durch Sputtern.

Neben dem Zusatz von 0,5 bis 5 Gewichtsprozent Kupfer können auch andere, weitere Zusätze an Metallen bzw. an Metalloiden, insbesondere an Silizium, dem Aluminium zugefügt werden. Ein Zusatz von circa 1 Gewichtsprozent Silizium hat sich ebenfalls als positiv zur Verbesserung gegenüber Elektromigration und Stressmigration erwiesen. Ferner ist dieser Zusatz an Silizium üblich, um die Diffusion von Silizium aus dem Substrat in Aluminium zu verhindern, welche insbesondere bei Kontaktlöchern unerwünscht ist.

Das Sputtern kann bei einer Temperatur unter 100°C erfolgen, welche eine sehr feinkörnige Struktur mit Aluminiumkorngrößen von 50 bis 100 nm erzielt. Vorzugsweise wird aber die Aluminiumschicht bei einer Substrattemperatur von 200 - 400°C aufgesputtert, so daß Aluminiumkörner nach dem Tempern mit einer Größe von mehreren µm erhalten werden können. Die daraus resultierenden Aluminiumleiterbahnen besitzen dann eine sogenannte "Bambusstruktur", da die Größe der Aluminiumkörner nun im Größenbereich der Breiten der Aluminiumleiterbahnen selbst liegen.

Nach dem Stand der Technik wird nun das Substrat mit der aufgesputterten und getemperten polykristallinen Aluminiumschicht abgekühlt.

Bei dem bisher unkontrolliert verlaufenden Abkühlen werden danach sogenannte Guinier-Preston-Zonen gebildet und es kommt während der Abkühlung zur Auslagerung von flächigen Kupferausscheidungen, den Guinier-Preston-Phasen. Danach wandern die Kupferatome aus den Flächen im Inneren der Aluminiumkörner an die Korngrenzen. Da die Guinier-Preston-Phasen instabil sind, wandeln diese sich anchließend in die stabilen Al₂Cu-θ-Phasen um. Dabei hinterlassen die ausgeschiedenen Kupferatome in den Aluminiumkörnern offene oder durch Versetzungen stark gestörte Gitterebenen, die von Aluminiumatomen nicht ausgeheilt werden können.

Aufgrund der bei der Inbetriebnahme und beim Gebrauch von integrierten Schaltkreisen auftretenden extrinsischen starken Zugspannungen kommt es schließlich zu einem spaltförmigen Aufreissen einzelner Aluminiumkörner, sogenannter Schlitzdefekte, und schließlich zum Riß ganzer Aluminiumleiterbahnen.

Wird nun nach der vorliegenden Erfindung nach der Beendigung des Temperns über einen definierten "Legierungs-Reifungsprozeß", das Ausbilden der instabilen Guinier-Preston-Phasen vermieden, so kommt es direkt zur Bildung der stabilen Al₂Cu-θ-Phasen. Dies wird durch ein kontrolliertes Abkühlen bewirkt, bei dem die momentane Temperatur ein vorgegebenes Temperaturprofil im Temperaturintervall von 320°C bis 200°C durchläuft. Dabei erfolgt eine zeitliche Änderung der Temperatur in diesem Temperaturintervall, die kleiner 6°C pro Stunde ist.

Die Legierungs-Reifung kann durch die Bestimmung des spezifischen Leitbahnwiderstandes nachgewiesen werden, der nach vollständiger Legierungs-Reifung ein Minimum einnimmt. Durch das erfindungsgemäße Verfahren wird die Lebensdauer gegenüber Elektromigration und Stressmigration um ein mindestens Drittel erhöht.

## Patentansprüche

1. Herstellverfahren für eine Aluminiumschicht auf einem Substrat mit folgenden Schritten:
a) auf das Substrat wird eine polykristalline Aluminiumschicht, die zwischen 0,5 bis 5 Gewichtsprozent Kupfer enthält, abgeschieden,
b) das Substrat wird mit der polykristallinen Aluminiumschicht in einen Ofen eingebracht und dort auf eine Zieltemperatur aufgeheizt,
c) danach wird das Substrat mit der polykristallinen Aluminiumschicht im Ofen von der Zieltemperatur auf eine Endtemperatur kontrolliert abgekühlt, so daß beim kontrollierten Abkühlen die momentane Temperatur ein vorgegebenes Temperaturprofil im Temperaturintervall von 320°C bis 200°C durchläuft und das Abkühlen im Temperaturintervall von 320°C bis 200°C mit einer zeitlichen Änderung der Temperatur kleiner 6°C pro Stunde erfolgt, wobei in der Aluminiumschicht zwischen den einzelnen Aluminiumkörnern direkt energetisch stabile Al₂Cu-θ-Phasen gebildet werden.

2. Herstellverfahren nach Anspruch 1,
**dadurch gekennzeichnet,**
**daß** das Substrat mit der polykristallinen Aluminiumschicht auf der Zieltemperatur getempert wird.

3. Herstellverfahren nach Anspruch 1 oder 2,
**dadurch gekennzeichnet,**
**daß** eine auf die Aluminiumschicht aufgebrachte Imidschicht auf der Zieltemperatur polymerisiert wird.

4. Herstellverfahren nach einem der Ansprüche 1 - 3,
**dadurch gekennzeichnet,**
**daß** die Zieltemperatur 350°C bis 450°C beträgt.

5. Herstellverfahren nach Anspruch 4,
**dadurch gekennzeichnet,**
**daß** beim kontrollierten Abkühlen die momentane Temperatur ein vorgegebenes Temperaturprofil im Temperaturintervall von 300°C bis 200°C durchläuft.

6. Herstellverfahren nach einem der Ansprüche 1 - 5,
**dadurch gekennzeichnet,**
**daß** die polykristalline Aluminiumschicht durch Sputtern bei einer Substrattemperatur von 200°C bis 400°C abgeschieden wird.

7. Herstellverfahren nach einem der Ansprüche 1 - 5,
**dadurch gekennzeichnet,**
**daß** die polykristalline Aluminiumschicht durch thermische oder induktive oder Elektronenstrahl-Verdampfung abgeschieden wird.

8. Herstellverfahren nach einem der Ansprüche 1 - 5,
**dadurch gekennzeichnet,**
**daß** die polykristalline Aluminiumschicht durch ein CVD-Verfahren abgeschieden wird.

9. Verwendung eines Herstellverfahrens nach einem der Ansprüche 1 - 9 zur Herstellung von Aluminiumleiterbahnen mit einer Breite ≤ 1 µm in einem integrierten Schaltkreis.

## Claims

1. Process for producing a layer of aluminium on a substrate, comprising the following steps:
a) a polycristalline aluminium layer which contains between 0.5 and 5 percent by weight of copper is deposited on the substrate,
b) the substrate with the polycristalline aluminium layer is introduced into a furnace, where it is heated to a target temperature,
c) then, the substrate with the polycristalline aluminium layer undergoes controlled cooling in the furnace from the target temperature to a final temperature, so that during the controlled cooling the instantaneous temperature passes through a predetermined temperature profile in the temperature range from 320°C to 200°C, and the cooling in the temperature range from 320°C to 200°C takes place with a change in the temperature over the course of time amounting to less than 6°C per hour, directly energy-stable Al₂Cu-θ phases being formed in the aluminium layer between the individual aluminium grains.

2. Production process according to Claim 1, **characterized in that** the substrate with the polycristalline aluminium layer is conditioned at the target temperature.

3. Production process according to Claim 1 or 2, **characterized in that** an imide layer which has been applied to the aluminium layer is polymerized at the target temperature.

4. Production process according to one of Claims 1-3, **characterized in that** the target temperature is 350°C to 450°C.

5. Production process according to Claim 4, **characterized in that** during the controlled cooling, the instantaneous temperature passes through a predetermined temperature profile in the temperature range from 300°C to 200°C.

6. Production process according to one of Claims 1-5, **characterized in that** the polycristalline aluminium layer is deposited by sputtering a substrate temperature of from 200°C to 400°C.

7. Production process according to one of Claims 1-5, **characterized in that** the polycristalline aluminium layer is deposited by thermal or inductive or electron beam vaporisation.

8. Production process according to one of Claims 1-5, **characterized in that** the polycristalline aluminium layer is deposited by means of a CVD process.

9. Use of a production process according to one of Claims 1-9 for producing aluminium interconnects having a width of ≤ 1 µm in an integrated circuit.

## Revendications

1. Procédé de production d'une couche d'aluminium sur un substrat comprenant les étape suivantes :
a) on dépose sur le substrat une couche d'aluminium polycristallin qui contient entre 0,5 et 5 % en poids de cuivre,
b) on met le substrat ayant la couche d'aluminium polycristallin dans un four et on l'y porte à une température cible,
c) on refroidit ensuite de manière contrôlée le substrat ayant la couche d'aluminium polycristallin dans le four de la température cible à une température finale, de sorte que, pendant le refroidissement contrôlé, la température instantanée parcourt un profil de température prescrit dans l'intervalle de températures de 320°C à 200°C et que le refroidissement s'effectue dans l'intervalle de températures de 320°C à 200°C avec une variation dans le temps de la température qui est inférieure à 6°C à la seconde, des phases énergétiquement stables d'Al₂Cu-θ se formant directement dans la couche d'aluminium entre les grains d'aluminium.

2. Procédé de production suivant la revendication 1, **caractérisé en ce que** l'on recuit le substrat ayant la couche d'aluminium polycristallin jusqu'à la température cible.

3. Procédé de production suivant la revendication 1 ou 2, **caractérisé en ce que** l'on polymérise une couche d'imide déposée sur la couche d'aluminium jusqu'à la température cible.

4. Procédé de production suivant l'une des revendications 1 à 3, **caractérisé en ce que** la température cible est comprise entre 350°C et 450°C.

5. Procédé de production suivant la revendication 4, **caractérisé en ce que** pendant le refroidissement contrôlé, la température instantanée parcourt un profil de température prescrit dans l'intervalle de températures de 300°C à 200°C.

6. Procédé de production suivant l'une des revendications 1 à 5, **caractérisé en ce que** l'on dépose la couche d'aluminium polycristallin par pulvérisation cathodique à une température du substrat allant de 200°C à 400°C.

7. Procédé de production suivant l'une des revendications 1 à 5, **caractérisé en ce que** l'on dépose la couche d'aluminium polycristallin par dépôt en phase vapeur par voie thermique ou inductive ou par un faisceau d'électron.

8. Procédé de production suivant l'une des revendications 1 à 5, **caractérisé en ce que** l'on dépose la couche d'aluminium polycristallin par un procédé CVD.

9. Utilisation d'un procédé de production suivant l'une des revendications 1 à 9, pour la production de pistes conductrices d'aluminium d'une largeur ≤ 1 µm dans un circuit intégré.
